# EUROPÄISCHE PATENTANMELDUNG

(11) **EP 2 988 139 A1**
(43) Veröffentlichungstag der Anmeldung: **24.02.2016**
(21) Anmeldenummer: 15178840.3
(22) Anmeldetag: 29.07.2015
(51) Int. Cl.: G01R 31/08, H01B 7/32, G08B 13/14, B60M 1/04

(54) **ÜBERWACHUNGSSYSTEM FÜR EIN STROMKABEL, STROMKABEL FÜR EIN SOLCHES ÜBERWACHUNGSSYSTEM SOWIE VERFAHREN ZUR ÜBERWACHUNG EINES STROMKABELS MIT HILFE EINES SOLCHEN ÜBERWACHUNGSSYSTEMS**

(30) Priorität: 18.08.2014 DE 102014111734
(71) Anmelder: DB Netz AG, 60329 Frankfurt (DE); Bayerische Kabelwerke AG, 91154 Roth (DE)
(72) Erfinder: Wolfsberger, Friedrich, 91152 Roth (DE); Boldt, Andreas, 15834 Rangsdorf (DE)
(74) Vertreter: Zinken-Sommer, Rainer

(57) **Zusammenfassung**

Das Überwachungssystem für Stromkabel (2), insbesondere für Erdungskabel oder Energiekabel bei Bahnanlagen umfasst dieses Stromkabel (2), welches einen Kabelkern (4) sowie einen Kabelmantel (8) aufweist. Im Stromkabel (2) sind mehrere Überwachungsleiter (14) integriert, welche elektrisch miteinander verschaltet sind, so dass eine Überwachungsstrecke (20) mit einer kabelindividuellen elektrischen Kenngröße zwischen zwei Signalanschlüssen (26) der Überwachungsstrecke (20) ausgebildet ist. Für unterschiedliche Stromkabel (2) werden dabei unterschiedliche kabelindividuelle elektrische Kenngrößen, insbesondere Widerstände (R1,R2) eingestellt. Dadurch ist ein Entwenden derartiger Stromkabel (2) erschwert, da selbst bei einem Überbrücken der Signalleiter (14) dies erkannt wird und somit ein Alarmsignal ausgegeben werden kann.

## Beschreibung

Die Erfindung betrifft ein Überwachungssystem für ein Stromkabel, insbesondere ein Stromkabel für Bahnanlagen, umfassend das Stromkabel, welches eine Mehrzahl von Einzeldrähten sowie einen äußeren Kabelmantel aufweist. Die Erfindung betrifft weiterhin ein Stromkabel für ein derartiges Überwachungssystem sowie ein Verfahren zur Überwachung eines derartigen Stromkabels mit Hilfe eines derartigen Überwachungssystems.

Unter Stromkabel werden vorliegend allgemein Kabel zur Energie- und Leistungsübertragung verstanden, die für die Übertragung von hohen (Dauer-) Strömen im Bereich von mehr als 5 Ampere, üblicherweise mehr als 100 Ampere und insbesondere auch für mehr als 1000 Ampere ausgebildet sind. Insbesondere handelt es sich um Stromkabel für Bahnanlagen, speziell um sogenannte Erdungskabel oder um sogenannte Energiekabel für eine Rückstromführung einer Bahnanlage.

Ein Erdungskabel sowie ein Überwachungssystem mit den Merkmalen des Oberbegriffs des Anspruchs 1 ist aus der DE 10 2013 005 901 A1 zu entnehmen.

Derartige Erdungskabel werden bei Installationen im Freien, wie beispielsweise bei Eisenbahneinrichtungen, zur elektrischen Erdung eingesetzt. Hierzu werden die Erdungskabel an die zu erdenden Gegenstände angeschlossen, also mit diesen elektrisch leitend verbunden. Unter Eisenbahneinrichtung werden dabei allgemein alle zu erdenden Einrichtungen in Bahnhofsbereichen oder in Bereichen von Bahntrassen verstanden, wie beispielsweise Handläufe oder auch Schallschutzwände und insbesondere die Eisenbahnschienen selbst. Im Falle der Eisenbahnschienen wird an deren Grundkörper in regelmäßigen Abständen das Erdungskabel üblicherweise mit Hilfe eines Kabelschuhs angeschraubt.

Energiekabel werden bei Bahnanlagen für die sogenannte Rückstromführung eingesetzt, um also die beispielsweise über eine Oberleitung dem Schienenfahrzeug zugeführte elektrische Energie wieder zurückzuführen, um einen geschlossenen Stromkreis auszubilden.

Die Stromkabel, also beispielsweise Erdungskabel oder Energiekabel für die Rückstromführung, bestehen dabei üblicherweise aus miteinander verseilten Einzellitzen, welche typischerweise wiederum aus einer Vielzahl von einzelnen Drähten aufgebaut sind. Als Material für die einzelnen Drähte wird dabei regelmäßig Kupfer eingesetzt.

Aufgrund des hohen Materialpreises für reines Kupfer werden derartige Stromkabel bei Installationen im Freien zunehmend entwendet. Durch diese Entwendung entstehen bei den Betreibern von Eisenbahneinrichtungen mitunter hohe Schäden.

Aus der DE 10 2003 005 001 A1 ist zur Vermeidung des Diebstahls derartiger Erdungskabel vorgesehen, dass innerhalb des Erdungskabels ein zentral angeordnetes Stützrohr integriert ist, durch das eine Überwachungsleitung geführt ist. Bei einem Durchtrennen des Erdungskabels wird auch die nach Art einer Signalleitung ausgebildete Überwachungsleitung unterbrochen. Die Überwachungsleitung wird dabei mit Hilfe einer Überwachungseinheit überwacht, so dass eine derartige Unterbrechung ein Alarmsignal auslöst.

Grundsätzlich besteht bei derartigen Überwachungssystemen mit in das Stromkabel integrierten Signalleitungen das Problem, dass die Signalleitungen teilweise von den Entwendern überbrückt werden, so dass also kein Signal erzeugt wird.

Ausgehend hiervon liegt der Erfindung die Aufgabe zugrunde, ein verbessertes Überwachungssystem für derartige Stromkabel, insbesondere für Erdungskabel oder Energiekabel zu ermöglichen.

Die Aufgabe wird gemäß der Erfindung gelöst durch ein Überwachungssystem mit den Merkmalen des Anspruchs 1. Dieses dient insbesondere zur Überwachung von Stromkabeln insbesondere bei Bahnanlagen. Bevorzugt werden damit Bahnerdungskabel, welche zur Erdung von Eisenbahneinrichtungen vorgesehen sind oder Energiekabel für die Rückstromführung überwacht. Das Stromkabel selbst weist eine Mehrzahl von üblicherweise als Litzen ausgebildeten Einzeldrähten auf, welche von einem äußeren Kabelmantel umgeben sind. Jedes Stromkabel weist mehrere Überwachungsleiter auf, wobei diese miteinander elektrisch leitend verschaltet sind, so dass eine Überwachungsstrecke mit einer kabelindividuellen Kenngröße zwischen zwei Signalanschlüssen der Überwachungsstrecke ausgebildet ist.

Die Erfindung wird nachfolgend ohne Beschränkung der Allgemeinheit im Zusammenhang mit einem Erdungskabel beschrieben.

Bei der kabelindividuellen elektrischen Kenngröße handelt es sich insbesondere um den elektrischen Widerstand der Überwachungsstrecke. Grundsätzlich besteht jedoch auch die Möglichkeit, dass eine andere elektrische oder auch magnetische Kenngröße der Überwachungsstrecke kabelindividuell eingestellt und entsprechend auch überwacht wird. Die Aufgabe wird weiterhin gemäß der Erfindung gelöst durch ein Erdungskabel mit den Merkmalen des Anspruchs 15 sowie durch ein Verfahren mit den Merkmalen des Anspruchs 16. Bevorzugte Weiterbildungen des Überwachungssystems sind in den Unteransprüchen enthalten. Diese sind sinngemäß auch auf das Erdungskabel sowie das Verfahren zu übertragen.

Die Ausgestaltung des Überwachungssystems mit der Einstellung einer kabelindividuellen elektrischen Kenngröße beruht dabei auf der Überlegung, für jedes einzelne Erdungskabel individuell eine zu den anderen Erdungskabeln verschiedene elektrische Kenngröße der Überwachungsstrecke einzustellen. Dadurch wird ein einfaches Überbrücken verhindert, da ein potenzieller Entwender nicht erkennen kann, welcher Wert für die kabelindividuelle elektrische Kenngröße bei dem aktuellen Erdungskabel eingestellt ist. Selbst bei einem Überbrücken lässt sich daher ein Entwenden noch feststellen, da die Überbrückungsstrecke nicht zielgerichtet auf die unbekannte kabelindividuelle elektrische Kenngröße eingestellt werden kann.

Durch die spezielle Ausgestaltung, dass in das Erdungskabel mehrere Überwachungsleiter integriert sind, welche miteinander zur Ausbildung der Überwachungsstrecke elektrisch verschaltet sind, lässt sich zudem in einfacher Weise die kabelindividuelle elektrische Kenngröße einstellen. Hierzu braucht lediglich von Kabel zu Kabel die Verschaltung der einzelnen Überwachungsleiter variiert zu werden. Während des Betriebs beim Verfahren zur Überwachung eines Erdungskabels wird daher die kabelindividuelle elektrische Kenngröße, die zwischen den zwei Signalanschlüssen der Überwachungsstrecke eingestellt ist, überwacht und für den Fall, dass eine Abweichung des aktuell erfassten Wertes von dem eingestellten Wert der Kenngröße Wert erfasst wird, wird ein Alarmsignal ausgegeben.

Die Überwachungsleiter sind dabei zweckdienlicherweise im Kabelmantel eingebettet. Vorzugsweise befinden sie sich ausschließlich im Kabelmantel.

Ein derartiges Erdungskabel weist üblicherweise einen Kabelkern auf, welcher typischerweise aus mehreren Lagen von einzelnen Litzendrähten ausgebildet ist, wobei die einzelnen Litzendrähte einen Verseilverbund bilden. Dieser ist schließlich von einem äußeren Kabelmantel umgeben, welcher häufig mehrschichtig, insbesondere zweischichtig ausgebildet ist und einen inneren Kabelmantel aufweist, beispielsweise aus Spezial-Polyvinylchlorid (Spezial-PVC) oder aus vernetztem Kunststoff (z.B. PE). Der innere Kabelmantel wiederum ist typischerweise umhüllt von einem äußeren Kabelmantel, bevorzugt aus Polyurethan (PUR). Üblicherweise ist dabei in den äußeren Kabelmantel noch eine Bewehrung eingebettet, welche eine Mehrzahl von Bewehrungsdrähten aufweist. Diese sind üblicherweise wendelförmig angeordnet und zueinander jeweils beabstandet.

Im Hinblick auf eine einfache kabelindividuelle Einstellung der elektrischen Kenngrößen sind in zweckdienlicher Ausgestaltung die Überwachungsleiter zumindest in Teilen unterschiedlich ausgebildet, so dass die unterschiedlichen Überwachungsleiter unterschiedliche elektrische Kenngrößen aufweisen, beispielsweise unterschiedliche elektrische Widerstände.

Insbesondere ist hierbei vorgesehen, dass die Überwachungsleiter sich im Hinblick auf ihre Geometrie, insbesondere ihren Durchmesser, unterscheiden.

In bevorzugter Alternative oder ergänzend zu den unterschiedlichen Geometrien bestehen die Überwachungsleiter aus unterschiedlichen Materialien, die sich im Hinblick auf die elektrische Kenngröße unterscheiden. So können beispielsweise neben Kupfer-Leitern auch Aluminium-Leiter eingesetzt werden oder es werden Leiter unterschiedlicher Legierungen miteinander kombiniert.

Zweckdienlicherweise sind die Überwachungsleiter weiterhin durch den Leiter einer Überwachungsader gebildet. Die Überwachungsleiter sind daher von einer Aderisolierung umgeben. Diese Überwachungsadern sind daher insbesondere innerhalb des Kabelmantels eingebettet. Die Ausgestaltung als Überwachungsader gewährleistet dabei, dass die in den Kabelmantel eingebetteten Überwachungsleiter, die im Kabelmantel parallel zueinander verlaufen, zueinander zuverlässig elektrisch isoliert sind. Bei unisolierten Leiterdrähten bestünde die Gefahr, dass diese beim Ausbilden des Kabelmantels mit den integrierten Überwachungsleitern, was üblicherweise durch einen Koextrusionsvorgang erfolgt, miteinander in Kontakt treten.

Vorzugsweise sind die Leitungsadern dabei um den Umfang verteilt angeordnet, insbesondere sind sie um den Umfang verteilt gleichmäßig angeordnet. Dabei sind typischerweise eine Vielzahl von Überwachungsleitern integriert, so dass eine möglichst große Anzahl von unterschiedlichen Schaltungsanordnungen der einzelnen Überwachungsleiter zur Ausbildung der Überwachungsstrecke ermöglicht ist. Bevorzugt werden dabei mehr als drei und insbesondere mehr als fünf Überwachungsleiter, beispielsweise fünf bis fünfzehn Überwachungsleiter, eingesetzt.

Wie zuvor bereits erwähnt, sind im Kabelmantel typischerweise Bewehrungsdrähte mit eingebettet. In bevorzugter Ausgestaltung ist nunmehr vorgesehen, dass zumindest ein Teil der Bewehrungsdrähte als Überwachungsleiter verwendet wird. Vorzugsweise werden neben den Überwachungsadern also auch Bewehrungsdrähte verwendet. Diese weisen daher eine Doppelfunktion auf.

Zweckdienlicherweise werden jedoch keine zwei benachbarten Bewehrungsdrähte als Überwachungsleiter verwendet, um einen Kontakt zu vermeiden.

Vorzugsweise ist weiterhin vorgesehen, dass zwischen zwei als Überwachungsleiter verwendeten Bewehrungsdrähten zumindest eine Überwachungsader angeordnet ist. Hierdurch wird zuverlässig vermieden, dass die Bewehrungsdrähte, die als Überwachungsleiter verwendet werden, sich berühren können.

Entsprechend ist daher auch vorgesehen, dass die Bewehrungsdrähte und die Überwachungsadern innerhalb einer gemeinsamen Lage, also bei gleichem radialem Abstand, zu einer Kabelmittenachse positioniert sind.

Im Hinblick auf eine möglichst einfache, kabelindividuelle Ausbildung der Verschaltung der einzelnen Überwachungsleiter erfolgt diese Verschaltung zweckdienlicherweise an einem Stirnende des Erdungskabels, an dem also die einzelnen Überwachungsleiter frei zugänglich sind. Hierzu ist insbesondere ein separates Kappenelement vorgesehen, in dem die einzelnen Überwachungsleiter kontaktiert sind und in dem ein Verschaltungsmuster zur Verschaltung der einzelnen Überwachungsleiter ausgebildet ist. Bei diesen Abschlusskappen kann es sich um vorgefertigte Bauteile handeln, die zueinander unterschiedliche Verschaltungsmuster aufweisen. Alternativ erfolgt die unterschiedliche Verschaltung vor Ort manuell, indem die Leiterenden in geeigneter Weise manuell miteinander verbunden werden. Auch besteht die Möglichkeit, dass beispielsweise das in der Endkappe integrierte Verschaltungsmuster manuell variierbar ist.

Zur Ausbildung der unterschiedlichen kabelindividuellen Überwachungsstrecken ist nunmehr vorgesehen, dass die Überwachungsleiter wahlweise in Reihe und/oder parallel verschaltet sind. Allein durch die Variation, welche der Überwachungsleiter seriell und welche parallel miteinander verschaltet werden, lassen sich auf einfache Weise kabelindividuelle Widerstände für die Überwachungsstrecke einstellen.

Zur Überwachung der elektrischen Kenngröße ist weiterhin eine Überwachungseinheit vorgesehen. Diese ist üblicherweise an einem Kabelende integriert und wertet die an den Signalanschlüssen abgegriffene elektrische Kenngröße aus.

In bevorzugter Ausgestaltung sind mehrere, insbesondere zwei Überwachungsstrecken ausgebildet, die sich im Hinblick auf die Werte der Kenngröße unterscheiden.

Die Überwachungsstrecken weisen vorzugsweise jeweils einen definierten elektrischen Widerstand auf, wobei die Widerstände der Überwachungsstrecken jeweils Teil einer Messbrücke der Überwachungseinheit sind. Durch diese Maßnahme lässt sich besonders einfach und hochgenau das Erdungskabel überwachen. Bei der Messbrücke handelt es sich dabei insbesondere um eine Wheatstonsche Messbrücke, welche auf die Widerstände der Überwachungsstrecken abgestimmt ist. Abweichungen der Widerstände der Messstrecken, beispielsweise infolge eines versuchten Überbrückens, führen zu einem Verstimmen der Messbrücke, welches von der Überwachungseinheit als Fehler erkannt wird. Damit ist insgesamt in einfacher Ausgestaltung eine zuverlässige Überwachung erzielt.

Im Hinblick auf einen effizienten Diebstahlschutz sind dabei dem Grundgedanken der Erfindung folgend unterschiedliche Erdungskabel mit unterschiedlichen Überwachungsstrecken mit unterschiedlichen Werten der elektrischen Kenngröße ausgebildet.

Im Hinblick auf die Inbetriebnahme und laufende Überwachung während des Betriebs wird zunächst in einem ersten Schritt kabelindividuell ein Wert für die elektrische Kenngröße erfasst und anschließend wird das Erdungskabel im Hinblick auf diesen kabelindividuellen Wert der elektrischen Kenngröße überwacht. Bei einem signifikanten Abweichen des während des Betriebs gemessenen Werts für die Kenngröße von dem zuvor erfassten Referenzwert wird ein Alarmsignal ausgegeben.

Der Referenzwert wird beispielsweise kabelindividuell vorgegeben, aufgrund der beim Kabelhersteller bzw. beim Monteur bekannten Verschaltung der einzelnen Überwachungsleiter. Der Referenzwert kann dabei beispielsweise aus einer Tabelle entnommen werden, in der unterschiedliche Verschaltungsmuster mit den zugehörigen Referenzwerten angegeben sind. Alternativ hierzu wird der Referenzwert nach dem Verschalten kabelindividuell ausgemessen.

Ausführungsbeispiele der Erfindung werden nachfolgend anhand der Figuren näher erläutert. Diese zeigen jeweils in vereinfachten Darstellungen:
- Fig. 1: einen Querschnitt durch ein Erdungskabel,
- Fig. 2: eine Seitenansicht auf ein Erdungskabel,
- Fig. 3 und 4: unterschiedliche Verschaltungsmuster zur Ausbildung einer kabelindividuellen elektrischen Kenngröße einer Überwachungsstrecke zusammen mit angeschlossener Überwachungseinheit.

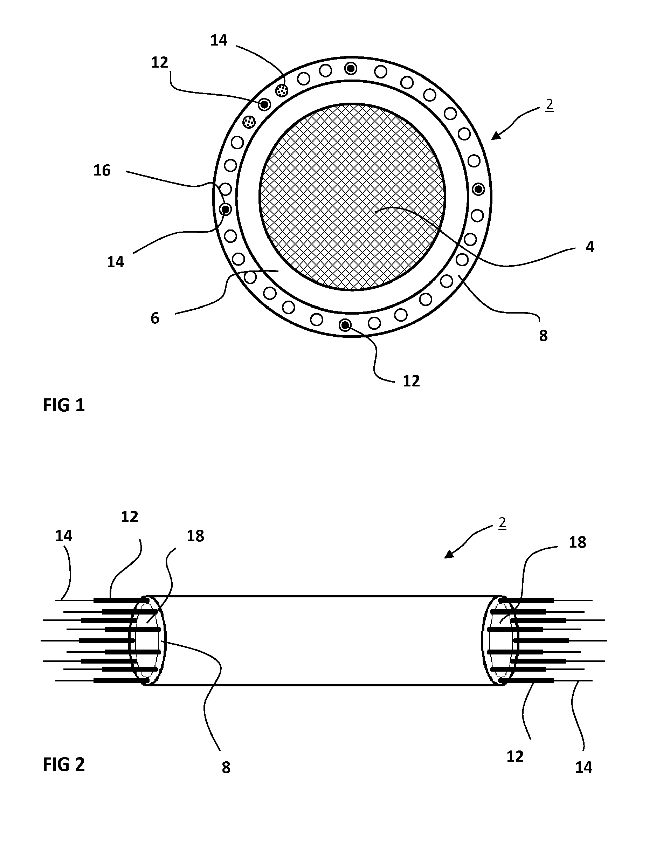

Ein in Fig. 1 dargestelltes, als Erdungskabel 2 ausgebildetes Stromkabel weist einen Kabelkern 4 auf, welcher von einem inneren Kabelmantel 6 und anschließend von einem äußeren Kabelmantel 8 umgeben ist. In den äußeren Kabelmantel 8 sind umlaufend eine Vielzahl von Bewehrungsdrähten 10 sowie mehrere Überwachungsadern 12 eingebettet. Die Überwachungsadern 12 sind dabei gebildet von einem Überwachungsleiter 14, welcher von einer Aderisolierung 16 umgeben ist. Weiterhin sind in der Fig. 1 beispielhaft zwei Bewehrungsdrähte 10 ebenfalls als Überwachungsleiter 14 verwendet. Zwischen diesen beiden als Überwachungsleiter 14 ausgebildeten Überwachungsdrähten 10 ist eine Überwachungsader 12 angeordnet. In Fig. 1 ist nur eine derartige Gruppe, bestehend aus zwei einander benachbarten und durch eine Überwachungsader 12 getrennten Bewehrungsdrähte 10 dargestellt. Alternativ können auch mehrere derartige Gruppen beispielsweise gleichmäßig verteilt angeordnet sein. Gleichermaßen sind auch die Überwachungsadern 12 vorzugsweise gleichmäßig verteilt in den äußeren Kabelmantel 8 eingebettet.

Der Kabelkern 4 besteht vorzugsweise aus mehreren Lagen von üblicherweise verseilten Einzeldrähten. Bei diesen handelt es sich üblicherweise um Litzendrähte, bestehend wiederum aus einer Vielzahl von einzelnen Feindrähten. Die einzelnen Litzendrähte liegen dabei unmittelbar aneinander an, ohne zwischenliegende Isolierung. Bei den Litzendrähten handelt es sich typischerweise um Kupfer-Litzendrähte. Alternativ können auch einige Nicht-Kupferdrähte in den Aufbau des Kabelkerns 4 integriert sein. Das Erdungskabel 2 und damit insbesondere der Kabelkern 4 ist zur Übertragung von hohen Strömen im Bereich von mehreren 100 Ampere ausgelegt. Insbesondere ist es als Starkstromkabel ausgebildet, welches für einen Dauerstrom beispielsweise im Bereich von 5 Ampere bis maximal 2000 Ampere ausgelegt ist. Gleichzeitig ist das Kabel typischerweise für Kurzschlussströme im Bereich von 20 Ampere bis zu 40000 Ampere ausgelegt.

Zur Herstellung des Erdungskabels 2 wird zunächst der Kabelkern 4 ausgebildet, auf den anschließend der innere Kabelmantel 6 aufextrudiert wird. Anschließend werden die Bewehrungsdrähte 10 sowie die Überwachungsadern 12 wendelförmig umlaufend auf den inneren Kabelmantel 6 aufgebracht, bevor schließlich der äußere Kabelmantel 8 als äußere Schutzhülle aufextrudiert wird. Die Bewehrungsdrähte 10 sowie die Überwachungsadern 12 sind damit im Material des äußeren Kabelmantels 8 eingebettet.

Wie insbesondere aus der Seitenansicht der Fig. 2 zu entnehmen ist, erstreckt sich das Erdungskabel 2 in Längsrichtung zwischen zwei Stirnenden 18. Das Erdungskabel 2 wird üblicherweise zunächst als Endlosware (Meterware) gefertigt und anschließend auf eine gewünschte Länge abgelängt.

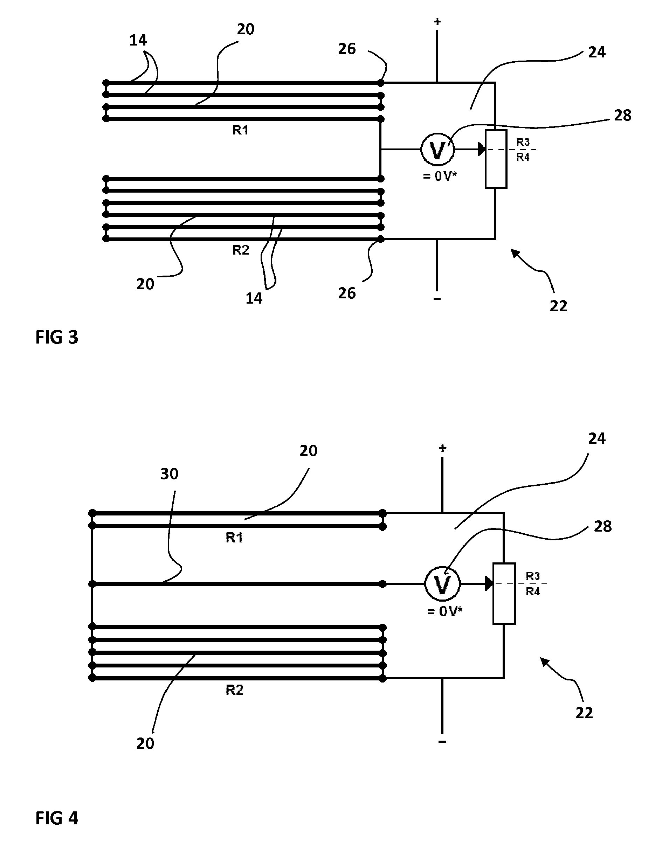

An den beiden Stirnenden 18 werden dann die einzelnen aus dem Kabelmantel 8 hervorstehenden Überwachungsleiter 14 in geeigneter Weise miteinander verschaltet, also elektrisch miteinander verbunden, so dass sich durch die Verschaltung der einzelnen Überwachungsleiter 14 zumindest eine Überwachungsstrecke 20 bildet (vgl. hierzu die Fig. 3 und 4), welche einen speziellen elektrischen Kennwert, insbesondere einen speziellen elektrischen Widerstand aufweist.

Die Verschaltung erfolgt hierbei in hier nicht näher dargestellter Weise an einem jeweiligen Stirnende 18. Dies kann durch ein manuelles elektrisches Verbinden der einzelnen Überwachungsleiter 14 erfolgen oder auch unter Zuhilfenahme eines vorgefertigten Verschaltungsmusters, welches in einer aufsetzbaren Kappe integriert ist. In diese Kappe werden beispielsweise die einzelnen Überwachungsleiter 14 in einfacher Weise nach Art eines Steckkontakts oder dergleichen, beispielsweise über Schneidklemmen elektrisch kontaktiert.

Zweckdienlicherweise unterscheiden sich dabei die einzelnen Überwachungsleiter 14 im Hinblick auf ihre individuellen elektrischen Kennwerte, insbesondere im Hinblick auf ihren elektrischen Widerstand. Hierzu weisen sie beispielsweise unterschiedliche Querschnitte, Durchmesser und/oder unterschiedliche Materialien auf.

Zur Ausbildung der Überwachungsstrecke 20 werden daher die einzelnen Überwachungsleiter 14 an ihren aus den Stirnenden 18 heraustretenden Enden elektrisch miteinander kontaktiert. Die Überwachung des elektrischen Kennwerts der dann ausgebildeten Überwachungsstrecke 20 wird mit Hilfe einer Überwachungseinheit 22 während des Betriebs kontrolliert und überwacht.

Hierzu ist im Ausführungsbeispiel der Fig. 3 und 4 jeweils eine Messbrücke 24 vorgesehen. Weiterhin sind insgesamt zwei Gruppen an Überwachungsleitern 14 jeweils zu einer Überwachungsstrecke 20 miteinander verbunden, so dass also zwei Überwachungsstrecken 20 jeweils mit einem spezifischen elektrischen Widerstand R1,R2 ausgebildet sind. Diese beiden zueinander vorzugsweise verschiedene Widerstände R1,R2 bilden dabei Widerstände der Messbrücke, die zwei weitere Messbrücken-Widerstände R3,R4 aufweisen. Diese sind insbesondere durch ein durchstimmbares Potenziometer gebildet. Bei der Messbrücke 24 handelt es sich insbesondere um eine wheatstonsche Messbrücke zur Messung der elektrischen Widerstände. Mit Hilfe eines Spannungsmessers 28, der mit Abgriffspunkten zwischen den Widerständen R1,R2 einerseits und R3,R4 andererseits verbunden ist, wird die zwischen diesen beiden Abgriffspunkten anliegende Spannung gemessen. Bei geeigneter Wahl der Widerstände R1-R4 ist bei abgestimmter Messbrücke 24 die gemessene Spannung 0 Volt.

Bei der Inbetriebnahme des Erdungskabels wird nunmehr derart vorgegangen, dass zunächst die Verschaltung der einzelnen Überwachungsleiter 14 erfolgt, so dass die Überwachungsstrecken 20 ausgebildet werden. Anschließend wird die Überwachungseinheit 22 zur Ausbildung der Messbrücke 24 wie dargestellt an Signalanschlüssen 26 sowie an den Spannungsabgriffen zwischen den Widerständen R1-R4 angeschlossen. Anschließend wird die Messbrücke 24 derart abgestimmt, dass der gemessene Spannungswert null ist.

Insoweit wird ein Referenzwert eingestellt, auf den nunmehr im nachfolgenden Betrieb die Überwachungseinheit 22 das Erdungskabel 2 überwacht. Wird das Erdungskabel durchtrennt und somit auch die Überwachungsleiter 14, so wird dies unmittelbar detektiert und von einer hier nicht näher dargestellten Auswerteeinheit als Fehler erfasst und es wird ein Alarmsignal ausgegeben. Ein derartiges Alarmsignal wird jedoch auch dann ausgegeben, wenn sich einer der beiden Widerstände R1,R2 ändert, beispielsweise wenn versucht wird, die Signalleiter zu überbrücken. Dies führt zu einem veränderten Widerstand R1 oder R2, so dass die Messbrücke verstimmt ist und dies auch als Fehler erkannt wird.

Wie aus der Fig. 3 zu entnehmen ist, sind zur Ausbildung der beiden Messüberwachungsstrecken 20 die einzelnen Leitungsadern 14 in Serie miteinander verschaltet. Die beiden Überwachungsstrecken 2 sind dabei durch eine unterschiedliche Anzahl an Überwachungsleitern 14 gebildet.

Bei der Ausführungsvariante gemäß der Fig. 4 sind demgegenüber die einzelnen Überwachungsleiter 14 parallel zueinander geschaltet. Grundsätzlich sind auch Kombinationen von Parallel- und Serienschaltungen möglich.

Bei der Ausführungsvariante der Fig. 4 liegt der erforderliche Messabgriff für den Spannungsmesser 28 auf der gegenüberliegenden Seite der Überwachungseinheit 22. Von daher wird einer der Überwachungsleiter 14 und/oder der Bewehrungsdrähte 10 als Rückleitung 30 verwendet.

### Bezugszeichenliste

- 2: Erdungskabel
- 4: Kabelkern
- 6: innerer Kabelmantel
- 8: äußerer Kabelmantel
- 10: Bewehrungsdrähte
- 12: Überwachungsader
- 14: Überwachungsleiter
- 16: Aderisolierung
- 18: Stirnende
- 20: Überwachungsstrecke
- 22: Überwachungseinheit
- 24: Messbrücke
- 26: Signalanschluss
- 28: Spannungsmesser
- 30: Rückleitung

- R1,R2: Widerstand
- R3,R4: Messbrücken-Widerstand

## Patentansprüche

1. Überwachungssystem für ein Stromkabel (2), insbesondere für ein Stromkabel einer Bahnanlage, umfassend das Stromkabel (2), welches eine Mehrzahl von Einzeldrähten sowie einen Kabelmantel (8) aufweist,
**dadurch gekennzeichnet,**
**dass** jedes Stromkabel (2) mehrere Überwachungsleiter (14) aufweist und diese miteinander elektrisch leitend verschaltet sind, so dass eine Überwachungsstrecke (20) mit einer kabelindividuellen Kenngröße zwischen zwei Signalanschlüssen (26) der Überwachungsstrecke (20) ausgebildet ist.

2. Überwachungssystem nach Anspruch 1,
**dadurch gekennzeichnet,**
**dass** die kabelindividuelle Kenngröße der Widerstand der Überwachungsstrecke (20) ist.

3. Überwachungssystem nach Anspruch 1 oder 2,
**dadurch gekennzeichnet,**
**dass** die Überwachungsleiter (14) im Kabelmantel (8) eingebettet sind.

4. Überwachungssystem nach einem der vorhergehenden Ansprüche,
**dadurch gekennzeichnet,**
**dass** die Überwachungsleiter (14) unterschiedlich ausgebildet sind, so dass sie zueinander verschiedene Werte der Kenngröße aufweisen.

5. Überwachungssystem nach einem der vorhergehenden Ansprüche,
**dadurch gekennzeichnet,**
**dass** die Überwachungsleiter (14) aus unterschiedlichen Materialien bestehen.

6. Überwachungssystem nach einem der vorhergehenden Ansprüche,
**dadurch gekennzeichnet,**
**dass** zumindest einige der Überwachungsleiter (14) zur Ausbildung von Überwachungsadern (12) von einer Aderisolierung (16) umgeben sind.

7. Überwachungssystem nach dem vorhergehenden Anspruch,
**dadurch gekennzeichnet,**
**dass** die Überwachungsadern (12) um den Umfang verteilt angeordnet sind.

8. Überwachungssystem nach einem der vorhergehenden Ansprüche,
**dadurch gekennzeichnet,**
**dass** im Kabelmantel (8) Bewehrungsdrähte (10) eingebettet sind und zumindest ein Teil der Bewehrungsdrähte (10) als Überwachungsleiter (14) verwendet sind.

9. Überwachungssystem nach den Ansprüchen 6 und 8,
**dadurch gekennzeichnet,**
**dass** zwei als Überwachungsleiter (14) verwendete, benachbarte Bewehrungsdrähte (10) durch zumindest eine Überwachungsader (12) voneinander getrennt sind.

10. Überwachungssystem nach einem der vorhergehenden Ansprüche,
**dadurch gekennzeichnet,**
**dass** das Stromkabel (2) zumindest ein Stirnende (18) aufweist und die Überwachungsleiter (14) am Stirnende (18) miteinander verschaltet sind.

11. Überwachungssystem nach einem der vorhergehenden Ansprüche,
**dadurch gekennzeichnet,**
**dass** mehrere der Überwachungsleiter (14) in Serie und/oder parallel verschaltet sind.

12. Überwachungssystem nach einem der vorhergehenden Ansprüche,
**dadurch gekennzeichnet,**
**dass** eine Überwachungseinheit (22) vorgesehen ist, die die Überwachungsstrecke (20) im Hinblick auf die elektrische Kenngröße überwacht.

13. Überwachungssystem nach dem vorhergehenden Anspruch,
**dadurch gekennzeichnet,**
**dass** mehrere Überwachungsstrecken (20) ausgebildet sind mit jeweils einem elektrischen Widerstand und dass die Widerstände der Überwachungsstrecken (20) Teil einer Messbrücke (24) der Überwachungseinheit (22) sind.

14. Überwachungssystem nach einem der vorhergehenden Ansprüche,
**dadurch gekennzeichnet,**
**dass** für unterschiedliche Erdungskabel (2) unterschiedliche Überwachungsstrecken (20) mit unterschiedlichen Werten der Kenngröße ausgebildet sind.

15. Stromkabel (2) für ein Überwachungssystem nach einem der vorhergehenden Ansprüche mit einer Mehrzahl von Einzeldrähten und einem Kabelmantel (8),
**dadurch gekennzeichnet,**
**dass** im Kabelmantel (8) mehrere als Überwachungsleiter (14) ausgebildete Leitungsadern integriert sind.

16. Verfahren zur Überwachung eines Stromkabels (2) mit Hilfe eines Überwachungssystems nach einem der Ansprüche1 bis 13, bei dem zunächst kabelindividuell ein Referenzwert für die Kenngröße erfasst wird und anschließend das Stromkabel (2) im Hinblick auf den kabelindividuellen Wert der Kenngröße überwacht wird.

17. Verfahren nach dem vorhergehenden Anspruch, bei dem der Referenzwert nach dem Verschalten der Überwachungsleiter (14) kabelindividuell ausgemessen wird.
